# EUROPÄISCHE PATENTSCHRIFT

(11) **EP 2 091 152 B1**
(45) Veröffentlichungstag und Bekanntmachung des Hinweises auf die Patenterteilung: **24.11.2010**
(21) Anmeldenummer: 08002577.8
(22) Anmeldetag: 12.02.2008
(51) Int. Cl.: H03K 17/18, H03K 19/007

(54) **Digitale Ausgabeschaltung und Ausgabebaugruppe mit einer Mehrzahl derartiger digitaler Ausgabeschaltungen**
Digital signal output control device and assembly with numerous such digital signal output control devices
Commutation d'émission numérique et composant d'émission doté d'une multitude de telles commutations d'émission numériques

(43) Veröffentlichungstag der Anmeldung: 19.08.2009
(73) Patentinhaber: SIEMENS AKTIENGESELLSCHAFT, 80333 München (DE)
(72) Erfinder: Maier, Willi, 77728 Oppenau (DE)

(56) Entgegenhaltungen:
- DE-A1- 1 903 694
- DE-A1- 2 223 039
- DE-U1-202006 001 681

## Beschreibung

Die Erfindung betrifft eine digitale Ausgabeschaltung zur parallelen Anschaltung an eine elektrische Last zusammen mit einer weiteren, insbesondere identischen digitalen Ausgabeschaltung. Die digitale Ausgabeschaltung weist einen elektrischen Eingang für ein digitales Eingangssignal, einen Versorgungsspannungseingang zum Anschalten einer Versorgungsgleichspannung mit einem vorgegebenen maximalen Nennspannungswert, einen elektrischen Lastausgang, einen durch das Eingangssignal ansteuerbaren Schalter zum Schalten der Versorgungsgleichspannung über eine Diode an den Lastausgang, einen Meldeausgang sowie eine Stromflusserkennungseinheit auf. Letztere ist in Reihe zum Schalter geschaltet. Über die Stromflusserkennungseinheit ist ein Meldesignal an den Meldeausgang ausgebbar, falls kein Stromfluss über den Schalter erkennbar ist.

Die Erfindung betrifft weiterhin eine Ausgabebaugruppe mit zumindest einer, insbesondere mit einer Mehrzahl von derartigen digitalen Ausgabeschaltungen.

In hochverfügbaren Systemen in der Automatisierungs- und Anlagentechnik ist es bekannt, digitale Ausgabeschaltungen redundant zu betreiben. Dabei werden jeweils zwei digitale Ausgabeschaltungen parallel an eine elektrische Last geschaltet. Dadurch wird erreicht, dass bei Ausfall einer der beiden digitalen Ausgabeschaltungen weiterhin eine Ausgabe an die Last möglich ist. Die Ansteuerung der Ausgabeschaltungen erfolgt typischerweise über eine übergeordnete Steuerung, wie z. B. über eine so genannte SPS (für speicherprogrammierbare Steuerung). Die Steuerung ist auch dazu ausgebildet, Diagnosedaten der digitalen Ausgabeschaltung auszuwerten und in einem Fehlerfall eine entsprechende Meldung auszugeben. In diesem Zusammenhang ist insbesondere eine sichere Drahtbruchkennung aller Leitungen des Lastzweiges wichtig.

Jedoch ist es mit der heutigen Schaltungstechnik nur unter idealen Verhältnissen möglich, Drahtbrüche in dem jeweiligen Lastzweig zu detektieren. Häufig kommt es vor, dass ein Großteil des Laststroms oder sogar der gesamte Laststrom, bedingt durch Toleranzen der elektronischen Bauelemente in den digitalen Ausgabeschaltungen, nur von einer der beiden Ausgabeschaltungen in die Last eingespeist wird. Die Ursache hierfür ist, dass bereits geringe Unterschiede zwischen den beiden an die Last durchgeschalteten Versorgungsgleichspannungen große Verschiebungen der Lastströme zur Folge haben können. Als Folge davon gibt dann eine der Stromflusserkennungseinheiten der Ausgabeschaltungen eine vermeintliche Drahtbruchmeldung aus, wenn der Großteil des Laststroms oder der gesamte Laststrom durch die andere Ausgabeschaltung eingespeist werden sollte. Aus diesem Grund wird in den meisten Fällen auf eine Auswertung einer solchen Meldung verzichtet.

Es ist somit eine Aufgabe der Erfindung, eine digitale Ausgabeschaltung anzugeben, welche mit hoher Sicherheit einen Leitungsbruch im Lastzweig der Ausgabeschaltung erkennt.

Die Aufgabe wird mit einer digitalen Ausgabeschaltung mit den Merkmalen des Patentanspruchs 1 gelöst. In den abhängigen Ansprüchen 2 bis 5 sind vorteilhafte Ausführungsformen der digitalen Ausgabeschaltung angegeben. Im Anspruch 6 ist eine Ausgabebaugruppe mit zumindest einer, insbesondere mit eine Mehrzahl von derartigen digitalen Ausgabeschaltungen genannt. Im abhängigen Anspruch 7 ist eine vorteilhafte Ausführungsform der Ausgabebaugruppe angegeben.

Erfindungsgemäß weist die digitale Ausgabeschaltung eine Spannungsversorgungseinheit zur Bereitstellung einer Hilfsspannung auf, welche in Bezug auf ein mit der Versorgungsgleichspannung gemeinsames Spannungspotential größer ist als der maximale Nennspannungswert von beiden parallel geschalteten digitalen Ausgabeschaltungen. Die digitale Ausgabeschaltung weist eine zumindest teilweise parallel zum Lastzweig angeordnete Prüfeinheit mit einem kurzzeitig ansteuerbaren Prüfschalter zum Einspeisen eines von der Hilfsgleichspannung gespeisten Prüfstroms zumindest mittelbar in die Last auf. Es ist dann über die Prüfeinheit das Meldesignal an den Meldeausgang ausgebbar, wenn kein Stromfluss über den Prüfschalter erkennbar ist.

Durch die im Vergleich zur maximalen vorgebbaren Versorgungsgleichspannung deutlich höhere Hilfsspannung wird erreicht, dass auf jeden Fall ein Strom über die Diode in die elektrische Last eingespeist wird. Im einfachsten Fall ist die Spannungsversorgungseinheit eine Stromquelle, welche einen begrenzten Prüfstrom von wenigen Milliampere bereitstellen kann und welche im Leerlauf eine vergleichsweise überhöhte, unbelastete Hilfsspannung bereitstellt. Üblicherweise reicht ein Prüfstromwert durch die angeschlossene Last von einigen Milliampere aus, um mittels der Prüfeinheit zuverlässig detektiert zu werden.

Nach einer Ausführungsform ist der Prüfstrom direkt am Lastausgang in die elektrische Last einspeisbar. Dadurch ist eine Drahtprüfung bis zum Ausgang der Ausgabeschaltung hin möglich.

Nach einer Ausführungsform ist zwischen der Prüfeinheit und dem Lastausgang eine weitere Diode geschaltet. Diese Diode verhindert eine eventuelle Rückspeisung eines in die Last hineinfließenden Stroms in die Prüfeinheit.

In einer weiteren Ausführungsform ist der Prüfschalter durch die Prüfeinheit zyklisch ansteuerbar. Mit "zyklisch" ist gemeint, dass fortlaufend kurzzeitige Prüfstromimpulse in die Last eingespeist werden. Die Zeitdauer ist dabei so gewählt, dass sich der Spannungszustand an der elektrischen Last nur unwesentlich ändert und als solche nicht von einem daran angeschlossenen Gerät im Sinne einer Schaltzustandsänderung erkannt wird. Typischerweise liegt die Impulsdauer im einstelligen Millisekundenbereich. Die Pulsfrequenz liegt vorzugsweise in einem Bereich von 5 Hz bis 50 Hz.

Vorzugsweise ist der Prüfschalter nach einer weiteren Ausführungsform der Erfindung nur dann ansteuerbar, wenn kein Stromfluss im Lastzweig erkennbar ist. Insbesondere wird der Prüfschalter nur dann angesteuert, wenn der Schalter zur Ausgabe einer logischen "1" durch das Eingangssignal schließend angesteuert wird und wenn dann kein Stromfluss im Lastzweig erkennbar sein sollte. Dadurch erfolgt eine Prüfung vorteilhaft nur dann, wenn es "berechtigten" Grund für einen Leitungsbruch im Lastzweig gibt.

Die Aufgabe der Erfindung wird weiterhin durch eine Ausgabebaugruppe, insbesondere mit einer elektronischen Ausgabebaugruppe mit zumindest einer derartigen digitalen Ausgabeschaltung gelöst. Vorzugsweise weist eine solche Ausgabebaugruppe eine Mehrzahl von digitalen Ausgabeschaltungen, wie z. B. acht, auf. Derartige Ausgabebaugruppen können z. B. als Steckmodul zum Einstecken in einem Steuergerät ausgebildet sein. Sie können alternativ als ein Busmodul zum Aufstecken auf einer Hutschiene ausgebildet sein. Weiterhin kann die Mehrzahl von digitalen Ausgabeschaltungen als eine elektronische Baueinheit, insbesondere als integrierte Schaltung bzw. als ein Mikrochip, realisiert sein.

Nach einer Ausführungsform der Ausgabebaugruppe weist diese eine gemeinsame Prüfeinheit auf, welche einen eingangsseitigen Multiplexer zur Erfassung der jeweiligen Schaltströme, einen ausgangsseitigen Multiplexer zur Einspeisung des Prüfstroms in die jeweilige Last und Mittel zum zyklischen Ansteuern der jeweiligen Schaltstellungen der Multiplexer aufweist. Dadurch reduziert sich der schaltungstechnische Aufwand für die Überwachung aller digitalen Ausgabeschaltungen erheblich.

Die Erfindung sowie vorteilhafte Ausführungen der Erfindung werden im Weiteren anhand der nachfolgenden Figuren näher beschrieben. Es zeigen:
- FIG 1: eine Anordnung von zwei parallel an eine Last ge- schalteten digitalen Ausgabeschaltungen nach dem Stand der Technik,
- FIG 2: beispielhaft eine erfindungsgemäße digitale Aus- gabeschaltung und
- FIG 3: beispielhaft eine elektronische Ausgabebaugruppe mit einer Vielzahl von digitalen Ausgabeschaltungen mit einer gemeinsamen Prüfeinheit gemäß der Erfin- dung.

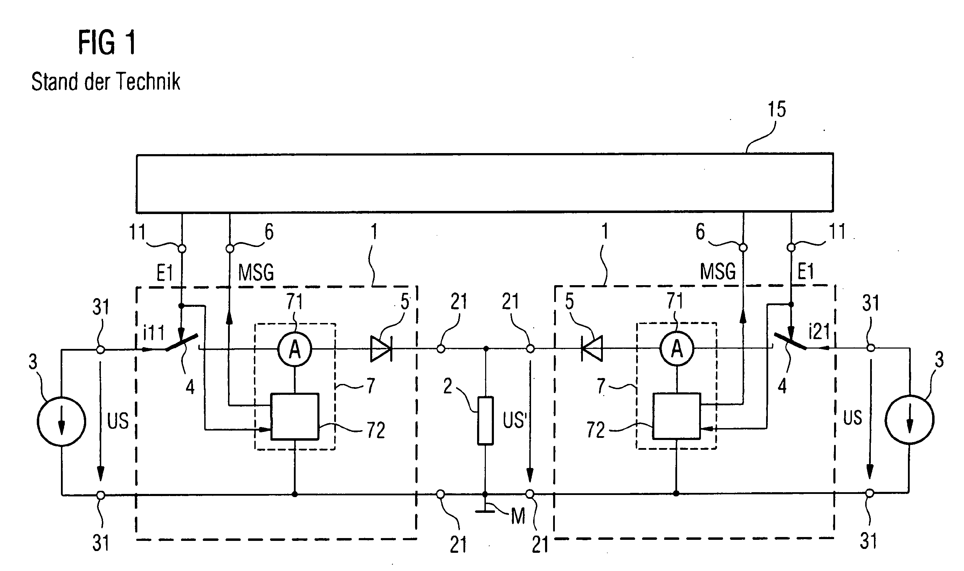

FIG 1 zeigt eine Anordnung von zwei parallel an eine Last 2 geschalteten digitalen Ausgabeschaltungen 1 nach dem Stand der Technik.

Im oberen Teil der FIG 1 ist eine Steuerung 15, insbesondere eine SPS, dargestellt. Diese ist über nicht weiter bezeichnete Verbindungsleitungen mit zwei parallel geschalteten digitalen Ausgabeschaltungen 1 zur Ausgabe eines digitalen Eingangssignals E1 für die Ausgabeschaltungen 1 sowie zum Empfang jeweils eines Meldesignals MSG verbunden. Letzteres zeigt typischerweise einen Drahtbruch in der jeweiligen betreffenden Ausgabeschaltung 1 an. Mit dem Bezugszeichen 11 ist ein jeweiliger elektrischer Eingang, mit dem Bezugszeichen 6 ein jeweiliger Meldeausgang der digitalen Ausgabeschaltung 1 bezeichnet.

Die beiden gezeigten Ausgabeschaltungen 1 sind über jeweils einen Lastausgang 21 an die gemeinsame Last 2 geschaltet. Mit US' ist die an der Last 2 anliegende Lastspannung bezeichnet. Sie ist typischerweise geringfügig kleiner als die eingangsseitig an einem jeweiligen Versorgungsspannungseingang 31 anliegende Versorgungsgleichspannung US. Zumindest ist diese Lastspannung US' um die über die jeweilige Diode 5 abfallende Durchlassspannung von typischerweise weniger als einem Volt reduziert. Mit M ist das gemeinsame Bezugspotential für beide parallel geschalteten digitalen Ausgabeschaltungen 1 bezeichnet. Zum Anschalten der Versorgungsgleichspannung US sind beispielhaft zwei Spannungsquellen bzw. Stromversorgungseinheiten 3 dargestellt. Üblicherweise werden die beiden Ausgabeschaltungen 1 parallel an dieselbe Stromversorgungseinheit 3 angeschaltet. Mit i11 bzw. i21 sind die von der Versorgungsgleichspannung US gespeisten Schaltströme bezeichnet, welche bei geschlossenem Schalter 4 über die jeweilige Diode 5 in die Last 2 fließen. Die beiden Schalter 4 werden über die Steuerung 15 gemeinsam angesteuert, sodass beide Schalter 4 gleichzeitig schließen. Der Schalter 4 kann z. B. ein Relaiskontakt sein. Er kann alternativ ein elektronisches Schaltelement sein, wie z. B. ein Transistor oder ein Optokoppler. Das Eingangssignal E1, welches von der Steuerung 15 ausgegeben wird, weist zwei Schaltzustände auf, in einem ersten Schaltzustand "0" wird der Schalter 4 typischerweise öffnend angesteuert. Bei einem Schaltzustand "1" wird der Schalter 4 schließend angesteuert. Mit anderen Worten liegt im Falle einer "0" keine Lastspannung US' bzw. eine Lastspannung US' mit einem Spannungswert von faktisch 0 Volt an der Last 2 an. Dagegen liegt bei einer "1" nahezu die an den Versorgungsspannungseingängen 31 anliegende Versorgungsgleichspannung US an der Last 2 an.

Die beiden gezeigten Ausgabeschaltungen 1 weisen eine Stromflusserkennungseinheit 7 auf, welche in Reihe zum Schalter 4 und zur Diode 5 geschaltet ist. Die Stromflusserkennungseinheit 7 weist beispielhaft eine Strommesseinheit 71 und eine damit verbundene Auswerteeinheit 72 auf. Übersteigt ein jeweiliger Schaltstrom i11, i21 einen vorgegebenen Vergleichswert, so gibt diese das Meldesignal MSG als digitales Signal an dem Meldeausgang 6 zur möglichen Weiterverarbeitung durch die angeschlossene Steuerung 15 aus.

Die jeweils an den digitalen Ausgabeschaltungen 1 anliegenden Versorgungsgleichspannungen US liegen typischerweise in einem Spannungsbereich von 20 V bis 30 V. Die maximalen Schaltströme i11, i21 betragen üblicherweise 500 mA. In einem solchen Fall kann ein Vergleichsstromwert von z. B. 5 mA als Vergleichswert für die Stromflusserkennungseinheit 7 festgelegt werden. Die beispielhaft genannten Schaltstromwerte können je nach Anwendungsfall und technischem Umfeld auch darüber oder darunter liegen, wie z. B. bei 100 mA oder bei 1 A oder 2 A. Der Vergleichsstromwert beträgt typischerweise nur ein Bruchteil des jeweiligen Schaltstromes i11, i21.

Im vorliegenden Beispiel erfasst weiterhin die Auswerteeinheit 72 zusätzlich das Eingangssignal E1, sodass das Meldesignal MSG nur dann an die Steuerung 15 ausgegeben wird, wenn bei geschlossenem Schalter 4 wider Erwarten kein Stromfluss erkennbar sein sollte.

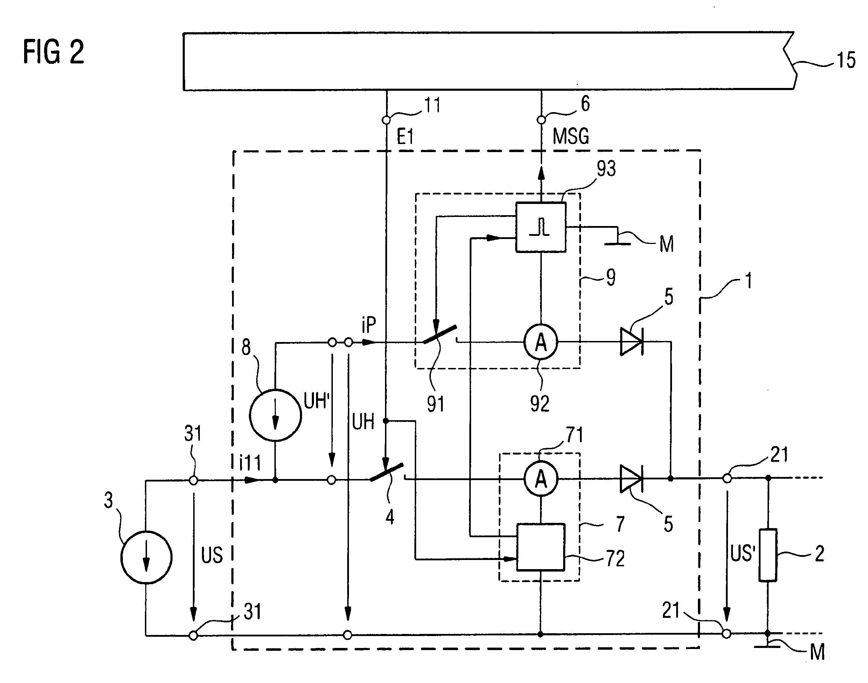

FIG 2 zeigt beispielhaft eine erfindungsgemäße digitale Ausgabeschaltung 1.

Im Unterschied zu der digitalen Ausgabeschaltung 1 nach dem Stand der Technik weist diese nun eine Spannungsversorgungseinheit 8 zur Bereitstellung einer Hilfsspannung UH auf. Die eingangsseitig anliegende Versorgungsgleichspannung US sowie die Hilfsspannung UH sind auf das gemeinsame Spannungspotential M bezogen. Die Hilfsspannung UH ist betragsmäßig größer als die Versorgungsgleichspannung US. Typischerweise ist diese um ca. 2 V bis 10 V größer als die Versorgungsgleichspannung US. Mit UH' ist eine Teilhilfsspannung bezeichnet, welche zusammen mit der in Reihe geschalteten Versorgungsgleichspannung US die Hilfsspannung UH ergibt. Weiterhin weist die eingangsseitig an den beiden digitalen Ausgabeschaltungen 1 anliegende Versorgungsgleichspannung US einen maximal vorgegebenen Nennspannungswert auf, wie z. B. 30 V.

Die digitale Ausgabeschaltung 1 weist gemäß der Erfindung eine zumindest teilweise parallel zum Lastzweig 4, 5, 7 angeordnete Prüfeinheit 9 auf. Im vorliegenden Beispiel ist die Prüfeinheit 9 gänzlich parallel zum Lastzweig 4, 5, 7 angeordnet. Sie weist weiterhin einen kurzzeitig ansteuerbaren Prüfschalter 91 zum Einspeisen eines von der Hilfsgleichspannung UH gespeisten Prüfstroms iP auf, welcher direkt in die elektrische Last 2 bei geschlossenem Prüfschalter 91 einspeisbar ist. Die Prüfeinheit 9 weist beispielhaft eine Auswerte-/Stromimpulseinheit 93 auf, welche kurzzeitig den Prüfschalter 91 zum Schließen ansteuert. Die Auswerte-/Stromimpulseinheit 93 ist auch bereits mit der Stromflusserkennungseinheit 7 verbunden, sodass der Prüfschalter 91 nur dann zum Schließen angesteuert wird, wenn ihr von der Prüfeinheit 7 kein Stromfluss signalisiert wird. In einem solchen Fall wird der Prüfschalter 91 zyklisch angesteuert, d. h. mit einer Reihe von Ansteuerimpulsen. Die Stromimpulsdauer liegt vorzugsweise in einem Bereich von wenigen Millisekunden. Die Wiederholungsfrequenz liegt vorzugsweise in einem Bereich von 5 bis 50 Hz. Weiterhin weist die Auswerte-/Stromimpulseinheit 93 eine Strommesseinheit 92 zur Erfassung des durch sie fließenden Prüfstroms iP auf. Erfindungsgemäß gibt dann die Prüfeinheit 9 das Meldesignal MSG an den Meldeausgang 6 aus, wenn über den Prüfschalter 91 nun kein Stromfluss erkennbar ist. Mit anderen Worten ist mittels der erfindungsgemäßen Prüfeinheit 9 feststellbar, dass kein Prüfstrom iP in die Last 2 eingeprägt werden kann und dass folglich ein Drahtbruch innerhalb der digitalen Ausgabeschaltung 1 und insbesondere "vor der Last" vorliegen muss.

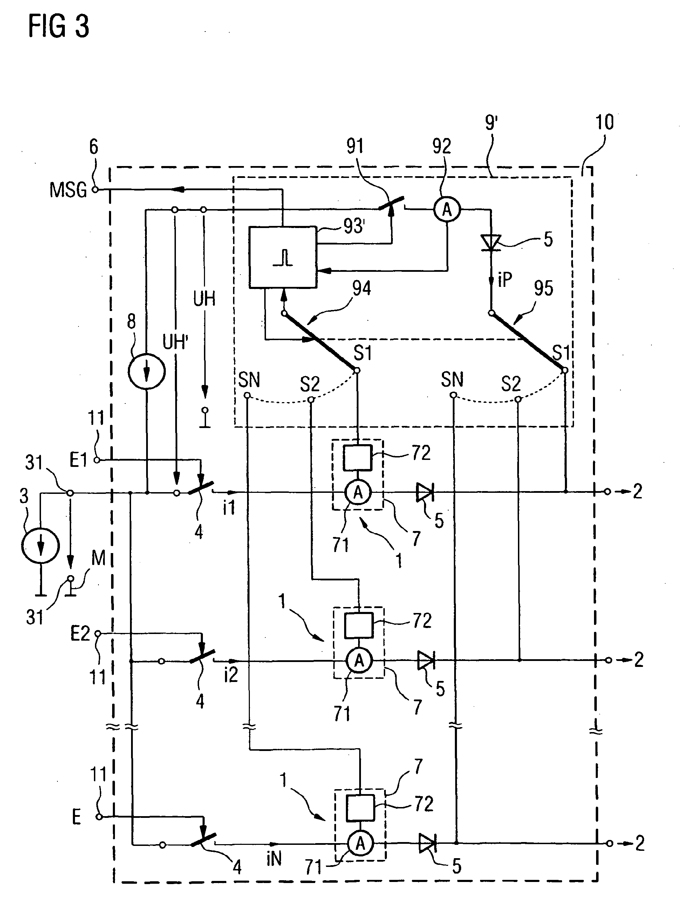

FIG 3 zeigt beispielhaft eine elektronische Ausgabebaugruppe 10 mit einer Vielzahl von digitalen Ausgabeschaltungen 1 und mit einer gemeinsamen Prüfeinheit 9'.

Im vorliegenden Beispiel sind beispielhaft nur drei digitale Ausgabeschaltungen 1 von insgesamt N möglichen digitalen Ausgabeschaltungen 1 dargestellt. Im oberen Teil der FIG 3 weist die gezeigte gemeinsame Prüfeinheit 9' einen eingangsseitigen Multiplexer 94, symbolisiert durch einen Drehschalter, sowie einen ausgangsseitigen Multiplexer 95 auf. Der eingangsseitige Multiplexer 94 ist zur Erfassung der jeweiligen Schaltströme i1, i2, iN vorgesehen. Der ausgangsseitige Multiplexer 95 ist zur Einspeisung des Prüfstroms iP in die jeweilige Last 2 vorgesehen. Weiterhin weist die gemeinsame Prüfeinheit 9' Mittel 93' zum zyklischen Ansteuern der jeweiligen Schaltstellungen S1, S2, SN der beiden Multiplexer 94, 95 auf. Die beiden Multiplexer 94, 95 werden somit synchron angesteuert. Stellt die gemeinsame Prüfeinheit 9' nun bei einer der zyklisch wiederkehrenden Schaltstellungen S1, S2, SN fest, dass kein Prüfstrom iP in die jeweilige Last 2 eingeprägt werden kann, so wird die entsprechende Fehlermeldung MSG an den Meldeausgang 6 ausgegeben. Die Prüfeinheit 93' kann darüber hinaus mit einem weiteren, in der FIG 3 nicht dargestellten Ausgang verbunden sein, um der übergeordneten Steuerung 15 anzuzeigen, welche der digitalen Ausgabeschaltungen 1 fehlerhaft ist. Alternativ kann diese Information zusammen mit dem Meldesignal MSG als serielle Signalfolge über denselben Meldeausgang 6 ausgegeben werden.

## Patentansprüche

1. Digitale Ausgabeschaltung zur parallelen Anschaltung an eine elektrische Last (2) zusammen mit einer weiteren, insbesondere identischen digitalen Ausgabeschaltung, mit einem elektrischen Eingang (11) für ein digitales Eingangssignal (E1), mit einem Versorgungsspannungseingang (31) zum Anschalten einer Versorgungsgleichspannung (US) mit einem vorgegebenen maximalen Nennspannungswert, mit einem elektrischen Lastausgang (21), mit einem durch das Eingangssignal (E1) ansteuerbaren Schalter (4) zum Schalten der Versorgungsgleichspannung (US) über eine Diode (5) an den Lastausgang (21), mit einem Meldeausgang (6) sowie mit einer Stromflusserkennungseinheit (7), welche in Reihe zum Schalter (4) geschaltet ist und über welche ein Meldesignal (MSG) an den Meldeausgang (6) ausgebbar ist, falls kein Stromfluss über den Schalter (4) erkennbar ist, **dadurch gekennzeichnet,**
- **dass** die digitale Ausgabeschaltung eine Spannungsversorgungseinheit (8) zur Bereitstellung einer Hilfsspannung (UH) aufweist, welche in Bezug auf ein mit der Versorgungsgleichspannung (US) gemeinsames Spannungspotential (M) größer ist als der maximale Nennspannungswert von beiden parallel geschalteten digitalen Ausgabeschaltungen, und
- **dass** die digitale Ausgabeschaltung eine zumindest teilweise parallel zum Lastzweig (4, 5, 7) angeordnete Prüfeinheit (9) mit einem kurzzeitig ansteuerbaren Prüfschalter (91) zum Einspeisen eines von der Hilfsgleichspannung (UH) gespeisten Prüfstroms (iP) zumindest mittelbar in die Last (2) aufweist, wobei dann über die Prüfeinheit (9) das Meldesignal (MSG) an den Meldeausgang (6) ausgebbar ist, wenn kein Stromfluss über den Prüfschalter (91) erkennbar ist.

2. Digitale Ausgabeschaltung nach Anspruch 1, **dadurch gekennzeichnet, dass** der Prüfstrom (iP) direkt am Lastausgang (21) in die elektrische Last (2) einspeisbar ist.

3. Digitale Ausgabeschaltung nach Anspruch 2, **dadurch gekennzeichnet, dass** zwischen der Prüfeinheit (9) und dem Lastausgang (21) eine weitere Diode (5) geschaltet ist.

4. Digitale Ausgabeschaltung nach Anspruch 3, **dadurch gekennzeichnet, dass** der Prüfschalter (91) durch die Prüfeinheit (9) zyklisch ansteuerbar ist.

5. Digitale Ausgabeschaltung nach Anspruch 4, **dadurch gekennzeichnet, dass** der Prüfschalter (91) nur dann ansteuerbar ist, wenn kein Stromfluss im Lastzweig (4, 5, 7) erkennbar ist.

6. Ausgabebaugruppe mit zumindest einer, insbesondere mit einer Mehrzahl von digitalen Ausgabeschaltungen (1) nach einem der vorangegangenen Ansprüche.

7. Ausgabebaugruppe nach Anspruch 6, **dadurch gekennzeichnet, dass** die Ausgabebaugruppe eine gemeinsame Prüfeinheit (9') aufweist, welche einen eingangsseitigen Multiplexer (94) zur Erfassung der jeweiligen Schaltströme (il, i2, iN), einen ausgangsseitigen Multiplexer (95) zur Einspeisung des Prüfstroms (iP) in die jeweilige Last (2) und Mittel (93') zum zyklischen Ansteuern der jeweiligen Schaltstellungen (S1, S2, SN) der Multiplexer (94, 95) aufweist.

## Claims

1. Digital signal output control device for parallel connection to an electrical load (2) together with a further, in particular identical digital signal output control device, comprising an electrical input (11) for a digital input signal (E1), a supply voltage input (31) for connecting a direct supply voltage (US) with a predetermined maximum nominal voltage value, an electrical load output (21), a switch (4) which can be controlled by the input signal (E1) for switching the direct supply voltage (US) via a diode (5) to the load output (21), an indication output (6) and a current flow identification unit (7), which is connected in series to the switch (4) and by way of which an indication signal (MSG) can be output to the indication output (6), if no current flow can be identified by way of the switch (4), **characterized in that**,
- the digital signal output control device comprises a voltage supply unit (8) for providing an auxiliary supply (UH), which, in respect of a voltage potential (M) which collaborates with the direct supply voltage (US), is greater than the maximum nominal voltage value of both digital signal output control devices which are connected in parallel, and
- the digital signal output control device comprises a test unit (9) which is arranged at least partially in parallel to the load branch (4, 5, 7) having a temporarily controllable test switch (91) for feeding a test current (iP) fed by the direct supply voltage (US) at least indirectly into the load (2), with it then being possible to output the indication signal (MSG) to the indication output (6) by way of the test unit (9), if no current flow over the test switch (91) can be identified.

2. Digital signal output control device according to claim 1, **characterized in that** the test flow (iP) can be fed directly into the electrical load (2) at the load output (21).

3. Digital signal output control device according to claim 2, **characterized in that** a further diode (5) is connected between the test unit (9) and the load output (21).

4. Digital signal output control device according to claim 3, **characterized in that** the test switch (91) can be cyclically controlled by the test unit (9).

5. Digital signal output control device according to claim 4, **characterized in that** the test switch (91) can only then be controlled if no current flow can be identified in the load branch (4, 5, 7).

6. Signal output assembly comprising at least one, in particular numerous digital signal output control devices (1) as claimed in one of the preceding claims.

7. Signal output assembly according to claim 6, **characterized in that** the signal output assembly comprises a shared test unit (9'), which comprises an input-side multiplexer (94) for detecting the respective switching currents (i1,i2,iN), an output-side multiplexer (95) for feeding the test current (iP) into the respective load (2) and means (93') for cyclically controlling the respective switching positions (S1, S2, SN) of the multiplexer (94, 95).

## Revendications

1. Circuit d'émission numérique, pour le montage en parallèle sur une charge ( 2 ) électrique, ensemble avec un autre circuit d'émission numérique, notamment identique, comprenant une entrée ( 11 ) électrique, pour un signal d'entrée numérique, une entrée ( 31 ) de tension d'alimentation, pour l'application d'une tension ( US ) continue d'alimentation ayant une valeur nominale maximum prescrite, une sortie ( 21 ) de charge électrique, un interrupteur ( 4 ) pouvant être commandé par le signal ( E1 ) d'entrée et destiné à appliquer la tension ( US ) continue d'alimentation, par l'intermédiaire d'une diode ( 5 ), à la sortie ( 21 ) de la charge, une sortie ( 6 ) d'avertissement, ainsi qu'une unité ( 7 ) de détection d'un flux de courant, qui est montée en série avec l'interrupteur ( 4 ) et par laquelle un signal ( MSG ) d'avertissement peut être émis sur la sortie ( 6 ) d'avertissement, dans le cas où on ne peut pas détecter de flux de courant par l'interrupteur ( 4 ), **caractérisé**
- **en ce que** le circuit d'émission numérique a une unité ( 8 ) d'alimentation en tension, pour mettre à disposition une tension ( UH ) auxiliaire, qui, rapportée à un potentiel ( M ) de tension commun avec la tension ( US ) continue d'alimentation, est plus haute que la valeur de tension nominale maximum des deux circuits d'émission numériques montés en parallèle, et
- **en ce que** le circuit d'émission numérique a une unité ( 9 ) de contrôle montée au moins en partie en parallèle à la branche ( 4, 5, 7 ) de charge et ayant un interrupteur ( 91 ) de contrôle pouvant être commandé brièvement, pour injecter un courant ( iP ) de contrôle fourni par la tension ( UH ) continue auxiliaire, au moins indirectement dans la charge ( 2 ), le signal ( MSG ) d'avertissement pouvant être alors émis par l'unité ( 9 ) de contrôle sur la sortie ( 6 ) d'avertissement, si l'on ne peut pas détecter de flux de courant par l'interrupteur ( 91 ) de contrôle.

2. Circuit d'émission numérique suivant la revendication 1, **caractérisé en ce que** le courant ( iP ) de contrôle peut être injecté dans la charge ( 2 ) électrique directement à la sortie ( 21 ) de la charge.

3. Circuit d'émission numérique suivant la revendication 2, **caractérisé en ce qu'**une autre diode ( 5 ) est montée entre l'unité ( 9 ) de contrôle et la sortie ( 21 ) de la charge.

4. Circuit d'émission numérique suivant la revendication 3, **caractérisé en ce que** l'interrupteur ( 21 ) de contrôle peut être commandé cycliquement par l'unité ( 9 ) de contrôle.

5. Circuit d'émission numérique suivant la revendication 4, **caractérisé en ce que** l'interrupteur ( 91 ) de contrôle ne peut être commandé que si l'on ne peut pas détecter de flux de courant dans la branche ( 4, 5, 7 ) de charge.

6. Module d'émission comprenant au moins un circuit ( 1 ) d'émission numérique et notamment une multiplicité de circuits ( 1 ) d'émission numériques suivant l'une des revendications précédentes.

7. Module d'émission suivant la revendication 6, **caractérisé en ce que** le module d'émission a une unité ( 9' ) de contrôle commune qui comporte un multiplexeur ( 94 ) du côté de l'entrée, pour détecter les courants ( i1, i2, iN ) de commutation respectifs, un multiplexeur ( 95 ) du côté de la sortie, pour l'injection du courant ( iP ) de contrôle dans la charge ( 2 ) respective et des moyens ( 93' ) de commande cyclique des positions ( S1, S2, SN ) de commutation respectives du multiplexeur ( 94, 95 ).
